Europäisches Patentamt

European Patent Office

Office européen des brevets

(19)

(11) **EP 1 416 497 A2**

(12) # DEMANDE DE BREVET EUROPEEN

(43) Date de publication:
**06.05.2004 Bulletin 2004/19**

(51) Int Cl.⁷: **G11C 11/56**

(21) Numéro de dépôt: **03300164.5**

(22) Date de dépôt: **16.10.2003**

(84) Etats contractants désignés:
**AT BE BG CH CY CZ DE DK EE ES FI FR GB GR HU IE IT LI LU MC NL PT RO SE SI SK TR**
Etats d'extension désignés:
**AL LT LV MK**

(30) Priorité: **31.10.2002 FR 0213694**

(71) Demandeur: **STMicroelectronics S.A.**
**92120 Montrouge (FR)**

(72) Inventeurs:
• **Wuidart, Luc**
  **83910 Pourrieres (FR)**
• **Bardouillet, Michel**
  **13790 Rousset (FR)**

(74) Mandataire: **de Beaumont, Michel**
  **1bis, rue Champollion**
  **38000 Grenoble (FR)**

(54) **Cellules mémoire multi-niveaux à programmation unique**

(57)    L'invention concerne une cellule mémoire multi-niveaux, comportant : un élément de mémorisation constitué de plusieurs résistances (Rp1, Rp2, Rp3, Rp4, Rp5, Rp6) en silicium polycristallin associées en série entre deux bornes (11, 12) d'entrée-sortie ; et une charge (Rf) en série avec ledit élément résistif, le point milieu (12) de cette association en série constituant une borne de lecture de la cellule mémoire, et les points milieux (14, 15, 17, 18, 19) respectifs entre lesdites résistances de l'élément de mémorisation étant accessibles.

Fig 3

**EP 1 416 497 A2**

**Description**

La présente invention concerne le domaine des cellules mémoire à programmation unique (OTP) et, plus particulièrement, de telles cellules mémoire dans lesquelles l'élément de mémorisation est constitué par un élément résistif en silicium polycristallin dans un circuit intégré.

L'élément résistif programmable se trouve alors en série avec un interrupteur de programmation, servant le cas échéant en même temps d'interrupteur de sélection de la cellule, et la programmation s'effectue de façon non destructrice (à la différence d'un élément fusible) en provoquant une diminution irréversible de la valeur de l'élément résistif en silicium polycristallin.

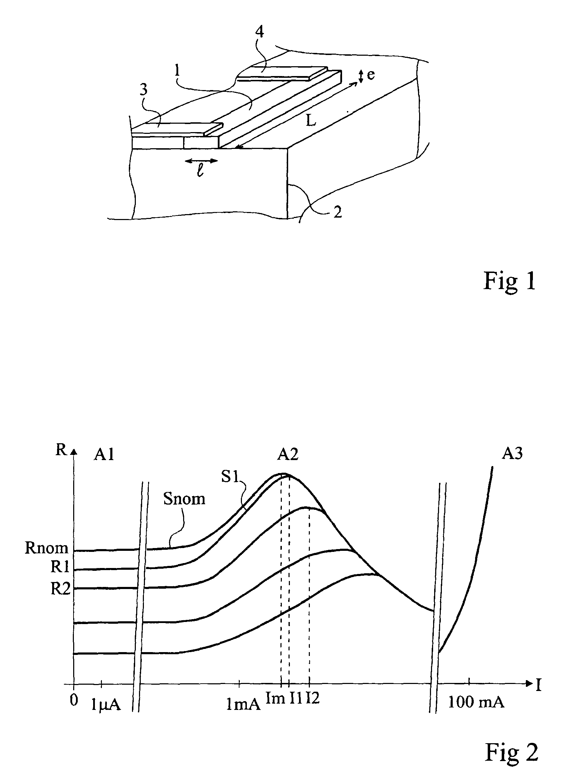

La figure 1 représente, par une vue partielle très schématique en perspective, un exemple de résistance en silicium polycristallin du type de celle utilisée dans une cellule mémoire à laquelle s'applique la présente invention.

Une telle résistance 1 est constituée d'une piste (dite aussi barreau) en silicium polycristallin obtenue par gravure d'une couche déposée sur un substrat 2 isolant. Le substrat 2 est indifféremment directement constitué du substrat du circuit intégré ou est constitué d'une couche isolante formant un substrat isolant ou équivalent pour la résistance 1. La résistance 1 est connectée, par ses deux extrémités, à des pistes conductrices (par exemple, métalliques) 3 et 4 destinées à raccorder le barreau résistif aux autres éléments du circuit intégré en fonction de l'application. La représentation schématique de la figure 1 ne fait pas référence aux différentes couches isolantes et conductrices constituant généralement le circuit intégré. Pour simplifier, on s'est contenté de représenter le barreau résistif 1 posé sur le substrat isolant 2 et en contact, par les extrémités de sa face supérieure, avec les deux pistes métalliques 3 et 4. En pratique, les liaisons de l'élément résistif 1 aux autres composants du circuit intégré sont obtenues par des pistes plus larges en silicium polycristallin partant des extrémités du barreau 1 dans l'alignement de celui-ci. En d'autres termes, l'élément résistif 1 est généralement formé en rendant un tronçon d'une piste en silicium polycristallin plus étroit que le reste de la piste.

La résistance R de l'élément 1 est donnée par la formule suivante :

$$R = \rho(L/s),$$

où $\rho$ désigne la résistivité du matériau (silicium polycristallin le cas échéant dopé) constituant la piste dans laquelle est gravé l'élément 1, où L désigne la longueur de l'élément 1, et où s désigne sa section, c'est-à-dire sa largeur 1 par son épaisseur e. La résistivité p de l'élément 1 dépend, entre autres, du dopage éventuel du silicium polycristallin le constituant. Dans certains cas, on recouvre l'élément de silicium polycristallin par une couche de métal, l'élément résistif combinant alors le silicium polycristallin et le métal sur-jacent.

Le plus souvent, lors de la réalisation d'un circuit intégré, on prévoit les résistances en faisant référence à une notion dite de résistance par carreau $R_\square$ (square résistance). Cette résistance par carreau se définit comme étant la résistivité du matériau divisée par l'épaisseur avec laquelle il est déposé. En reprenant la relation ci-dessus donnant la résistance d'un élément 1, la résistance est donc donnée par la relation :

$$R = R_\square * L/1.$$

Le quotient L/1 correspond à ce que l'on appelle le nombre de carreaux (square number) constituant l'élément résistif 1. Cela représente, vu de dessus, le nombre de carreaux de dimension donnée fonction de la technologie, mis côte à côte pour former l'élément 1.

La valeur de la résistance en silicium polycristallin est donc définie, à la fabrication, d'après les paramètres ci-dessus. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Dans les technologies récentes, le recours à des résistances en silicium polycristallin est limité aux résistances devant être traversées, en fonctionnement, par des courants inférieurs à 100 µA. Pour des courants supérieurs, on utilise généralement une résistance de diffusion. Le silicium polycristallin est toutefois préféré à une diffusion de dopants, car on évite l'apparition de capacités parasites avec le substrat.

Pour diminuer irréversiblement la valeur d'une résistance en silicium polycristallin, on impose temporairement un courant dit de contrainte pour lequel la résistance passe par une valeur maximale, ce courant étant au-delà de la plage de courants de fonctionnement normal de cette résistance. En d'autres termes, on diminue la résistivité du silicium polycristallin dans la plage de courants de fonctionnement, de façon stable et irréversible, en imposant dans l'élément résistif correspondant la circulation d'un courant au-delà de la plage de courants de fonctionnement.

Le courant servant à diminuer la valeur de la résistance est, à la différence d'un élément fusible, non destructif pour l'élément en silicium polycristallin.

La figure 2 illustre, par un réseau de courbes donnant la résistance d'un élément en silicium polycristallin du type de celui représenté en figure 1 en fonction du courant le traversant, la façon de diminuer la résistance de cet élément.

On suppose que le silicium polycristallin ayant servi à la fabrication de l'élément résistif 1 présente une résistivité nominale conférant à l'élément 1, pour les dimensions 1, L et e données, une valeur de résistance

$R_{nom}$. Cette valeur nominale (d'origine) de la résistance correspond à la valeur prise de façon stable par l'élément résistif 1 dans la plage de courants de fonctionnement du système, c'est-à-dire généralement pour des courants inférieurs à 100 µA.

Pour diminuer la valeur de la résistance et passer, par exemple, de façon irréversible et stable à une valeur R1 inférieure à $R_{nom}$, on applique aux bornes de l'élément résistif 1 un courant (par exemple I1), dit de contrainte, supérieur à un courant Im pour lequel la valeur de la résistance R de l'élément 1 est maximale sans toutefois être infinie. Comme l'illustre la figure 2, une fois que ce courant I1 a été appliqué à l'élément résistif 1, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 µA). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 2, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliquée pendant la phase de diminution irréversible. On notera en effet que la diminution irréversible opérée par l'invention s'effectue dans une phase spécifique, hors du fonctionnement normal (plage A1) du circuit intégré, c'est-à-dire hors du fonctionnement normal de la résistance.

Une fois que la valeur de la résistance en silicium polycristallin a été abaissée vers une valeur inférieure (par exemple R1 en figure 2), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$.

On voit que toutes les allures de la résistance en fonction du courant se rejoignent sur la pente de décroissance de la valeur de la résistance, après être passées par le maximum de l'allure. Ainsi, pour un élément résistif donné (p, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint. En fait, le courant provoque une élévation de température de l'élément en silicium, ce qui entraîne un fluage de celui-ci.

Bien sûr, on veillera à ne pas dépasser la plage de courants de paramétrage A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 1, on réalisera des vias dans l'isolant sur-jacent (non représenté) du barreau de silicium polycristallin pour connecter des pistes métalliques 3 et 4 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes donnés. En d'autres termes, pour un élément de dimensions données, cela conditionne le point de départ de la valeur de la résistance, et par voie de conséquence, les valeurs de résistance obtenues pour des courants de contrainte donnés.

Pour passer de la valeur nominale à une valeur de résistance ou résistivité inférieure, ou pour passer d'une valeur donnée (inférieure à la valeur nominale) à une valeur encore inférieure, on peut utiliser plusieurs méthodes.

Par exemple, on fait croître progressivement (pas à pas) le courant dans la résistance. Après chaque application d'un courant supérieur, on revient dans la plage de courants de fonctionnement et on mesure la valeur de la résistance. Tant que le point Im de courant n'est pas atteint, cette valeur de résistance restera à la valeur $R_{nom}$. Dès que le point Im en courant est dépassé, on change de courbe (allure S) et la valeur mesurée lorsque l'on repasse sur les courants de fonctionnement devient une valeur inférieure à la valeur $R_{nom}$. Si cette nouvelle valeur convient, on en reste là. Dans le cas contraire, on réapplique des courants supérieurs pour dépasser la nouvelle valeur maximale de l'allure courante. Dans ce cas, il n'est pas nécessaire de repartir des courants minimaux comme lorsque l'on démarre de la résistance nominale. En effet, la valeur du courant pour laquelle la résistance va de nouveau diminuer est forcément supérieure à la valeur du courant de contrainte I1 appliqué pour passer sur l'allure courante. La détermination du pas à appliquer est à la portée de l'homme du métier et n'est pas critique en ce qu'elle conditionne essentiellement le nombre de diminutions possibles. Plus le pas est élevé, plus les sauts entre les valeurs seront importants.

Selon un autre exemple préféré, on prédétermine, par exemple par mesures, les différents courants à appliquer pour passer des différentes valeurs de résistance à des valeurs inférieures. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 2 peuvent également être lues comme allure de la résistance par carreau, on est en mesure de transposer les valeurs calculées aux différentes résistances d'un circuit intégré définies par les largeurs et longueurs des tronçons résistifs. Selon ce deuxième mode de mise en oeuvre, on est alors en mesure de prédéterminer la valeur du courant de contrainte à appliquer à l'élément résistif pour diminuer, de façon irréversible et stable, sa valeur.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si dans une application particulière on considère ne pas pouvoir négliger l'influence de la durée d'application de la contrainte, les deux méthodes sont parfaitement compatibles avec la prise en compte de la durée d'application de la contrainte.

Le fait que l'on puisse diminuer plusieurs fois la valeur de la résistance par rapport à sa valeur issue de fabrication en appliquant successivement des courants de contrainte de plus en plus grands peut laisser entrevoir une cellule mémoire multi-niveaux. En effet, on peut prévoir de programmer plusieurs fois (un nombre fini de fois) une cellule mémoire comprenant un élément résistif du type décrit ci-dessus pour diminuer plusieurs fois la valeur de cet élément résistif. En détectant les différences de valeurs de l'élément résistif (par exemple, par une mesure de la tension à ses bornes alors qu'il est intégré dans un pont diviseur résistif), on peut envisager de réaliser une cellule mémoire multiniveaux.

Toutefois, la lecture d'une telle cellule mémoire est particulièrement complexe dans la mesure où l'amplificateur de lecture doit être capable de distinguer les niveaux analogiques qui ne peuvent pas être prédéterminés de façon aisée.

De plus, l'application de différents courants de contraintes à l'élément résistif selon la valeur que l'on souhaite y programmer serait une opération très délicate. En effet, les différents niveaux de courant à obtenir conduisent à une réalisation analogique qui est généralement difficilement compatible avec la réalisation d'une mémoire en circuit intégré pour laquelle on souhaite essentiellement, au moins pour la commande, des niveaux logiques.

Il serait toutefois souhaitable de pouvoir tirer profit de la capacité de programmation d'éléments résistifs en silicium polycristallin par diminution irréversible de la valeur de leur résistance, qui constitue un moyen particulièrement adapté pour rendre invisible (notamment par une observation optique) l'état programmé dans une cellule mémoire.

La présente invention vise à proposer une cellule mémoire multi-niveaux à programmation unique (ou à tout le moins un nombre limité de fois) qui soit compatible avec une commande en programmation au moyen de signaux logiques.

L'invention vise également à proposer une telle cellule mémoire dont la lecture du niveau programmé puisse s'effectuer dans une technologie compatible avec une technologie logique.

L'invention vise également à proposer une solution qui ne requiert pas d'appliquer aux bornes de l'élément résistif à programmer, pour appliquer un courant de contrainte, une tension supérieure à la tension de fonctionnement de la cellule mémoire.

Pour atteindre ces objets et d'autres, la présente invention prévoit une cellule mémoire multi-niveaux, comportant :

un élément de mémorisation constitué de plusieurs résistances en silicium polycristallin associées en série entre deux bornes d'entrée-sortie ; et
une charge en série avec ledit élément résistif, le point milieu de cette association en série constituant une borne de lecture de la cellule mémoire, et les points milieux respectifs entre lesdites résistances de l'élément de mémorisation étant accessibles.

Selon un mode de réalisation de la présente invention, au moins certains points parmi lesdits points milieux de l'élément de mémorisation et le point milieu entre cet l'élément et la charge, sont connectables, individuellement par un commutateur, soit à une desdites bornes d'entrée-sortie de l'élément de mémorisation, soit à une borne d'application d'un potentiel prédéterminé.

Selon un mode de réalisation de la présente invention, les extrémités d'une même résistance ne sont pas connectables à la même borne.

Selon un mode de réalisation de la présente invention, lesdits commutateurs sont constitués de transistors MOS répartis pour moitié en transistors à canal P et en transistors à canal N.

Selon un mode de réalisation de la présente invention, toutes les résistances en silicium polycristallin ont des valeurs nominales identiques.

Selon un mode de réalisation de la présente invention, le nombre de niveaux programmables possibles correspond, au maximum, au nombre de résistances en silicium polycristallin de l'élément de mémorisation, plus un.

Selon un mode de réalisation de la présente invention, la programmation s'effectue en imposant, dans une ou plusieurs desdites résistances en silicium polycristallin de l'élément de mémorisation, un courant de contrainte supérieur à un courant pour lequel la valeur de cette résistance présente un maximum.

Selon un mode de réalisation de la présente invention, ledit courant de contrainte est situé au-delà d'une plage de courant de fonctionnement en lecture de l'élément de mémorisation.

L'invention prévoit également un circuit de lecture d'au moins une cellule mémoire, comportant un ensemble de comparateurs recevant respectivement, sur une première entrée, la tension aux bornes d'entrée-sortie de l'élément de mémorisation et, sur une deuxième entrée, une tension de référence choisie en fonction d'un niveau à détecter par le comparateur parmi les niveaux possibles souhaités.

Selon un mode de réalisation de la présente invention, le circuit comporte un comparateur de moins qu'il existe de niveaux que l'on souhaite distinguer dans la cellule mémoire, et un ensemble de portes logiques générant autant d'états qu'il y a de comparateurs, le mot binaire fourni par ledit ensemble représentant l'état de la cellule mémoire.

Selon un mode de réalisation de la présente invention, le circuit comporte un nombre de comparateurs égal au double du nombre de niveaux que l'on souhaite distinguer dans la cellule, les sorties des comparateurs étant combinées deux à deux dans l'ordre croissant des tensions de référence qu'il reçoivent, pour détecter un niveau par paire de comparateurs.

L'invention prévoit également un procédé de programmation d'une cellule mémoire multi-niveaux.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 décrite précédemment représente, de façon partielle et très schématique, un exemple d'élément résistif en silicium polycristallin du type de ceux utilisables par la présente invention ;
la figure 2 décrite précédemment illustre, par un réseau de courbes représentant la valeur de la résistance en fonction du courant dans un élément de silicium polycristallin tel que représenté en figure 1, la mise en oeuvre d'une diminution irréversible de la valeur de cet élément résistif utilisé par l'invention ;
la figure 3 représente un premier mode de réalisation d'une cellule mémoire multi-niveaux à programmation unique selon la présente invention ;
la figure 4 représente un premier mode de réalisation d'un amplificateur de lecture d'une cellule mémoire ou d'un réseau de cellules mémoire tel qu'illustré par la figure 3 ; et
la figure 5 représente un deuxième mode de réalisation d'un amplificateur de lecture d'une cellule mémoire ou d'un réseau de cellules mémoire tel qu'illustré par la figure 3.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les circuits de commande propres à sélectionner une cellule mémoire de façon appropriée dans un réseau matriciel n'ont pas été détaillés et ne font pas l'objet de la présente invention. Celle-ci pourra être mise en oeuvre avec des circuits de sélection de lignes et/ou de colonnes classiques ou, à tout le moins, dont les adaptations sont à la portée de l'homme du métier à partir des indications fonctionnelles qui seront données. De plus, la réalisation pratique de tronçons résistifs en silicium polycristallin par dépôt et gravure n'a pas été détaillée, l'invention pouvant être mise en oeuvre par des techniques de fabrication classiques. De préférence, le silicium polycristallin constitutif des éléments résistifs de l'invention n'est pas soumis à un dépôt métallique classiquement utilisé pour diminuer la résistance des grilles du transistor MOS.

Une caractéristique de la présente invention est de prévoir un découpage de l'élément résistif constituant l'élément de mémorisation de la cellule mémoire en plusieurs résistances qui sont rendues individuellement programmables par un réseau de commutateurs. Le réseau de commutateurs sert à sélectionner une ou plusieurs des résistances individuelles qui ont préférentiellement des valeurs nominales identiques, pour programmer une valeur prédéterminée de l'élément résistif.

Selon l'invention, le nombre de résistances constituant un élément résistif conditionne le nombre de niveaux possibles de la cellule mémoire. De préférence, ces niveaux sont des niveaux discrets en ce sens que le courant de contrainte appliqué à une résistance à programmer est prédéterminé et identique pour toutes les résistances de la cellule mémoire, et plus généralement pour toutes les résistances d'un éventuel réseau matriciel de cellules mémoire.

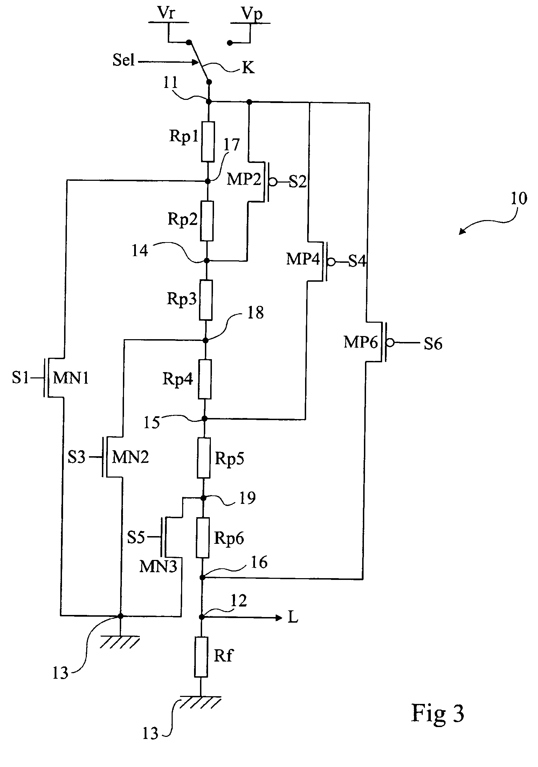

La figure 3 représente un mode de réalisation d'une cellule mémoire 10 selon la présente invention.

Dans l'exemple représenté en figure 3, on suppose la réalisation d'une cellule mémoire à sept niveaux prédéterminés. L'élément résistif programmable est alors constitué d'une association en série de six résistances Rp1 à Rp6 constituées chacune d'un tronçon de silicium polycristallin tel qu'illustré par la figure 1. Les résistances Rp1 à Rp6 sont associées en série entre deux bornes 11 et 12 de l'élément résistif programmable. La valeur de cet élément résistif correspond donc à la somme des valeurs individuelles des résistances Rp1 à Rp6. Le niveau stocké dans la cellule mémoire est lu sur une de ces deux bornes, par exemple au moyen d'une résistance fixe Rf constituant une résistance de charge permettant de former un pont diviseur résistif dont le point milieu 12 constitue une borne de lecture. Pour une telle lecture, une tension Vr est appliquée à l'autre borne 11 de la cellule mémoire 10, de préférence, par l'intermédiaire d'un interrupteur K jouant le rôle d'un interrupteur de sélection de la cellule si celle-ci est associée en colonne et/ou en ligne à d'autres cellules.

L'interrupteur K est commandé par un signal de sélection Sel de façon classique. Dans le cas d'une association de plusieurs cellules mémoire, la résistance de charge Rf peut être partagée par toutes les cellules d'une même colonne ou rangée sélectionnable par l'interrupteur K. En outre, cet interrupteur peut servir lors d'un souhait de programmation de la cellule 10 pour appliquer une tension différente Vp de programmation supérieure à la tension Vr, si cela est nécessaire pour provoquer les diminutions irréversibles des valeurs des résistances Rp1 à Rp6.

Pour assurer la programmation de l'élément résistif de la cellule, on permet une sélection individuelle des résistances Rp1 à Rp6 à soumettre à un courant de contrainte pour diminuer leur valeur. Dans un premier exemple, on fera référence à l'application d'une tension de programmation Vp sachant que cette tension de programmation peut, avec certaines précautions, correspondre à la tension Vr de lecture comme cela sera expliqué par la suite.

Dans l'exemple représenté, on prévoit de connecter chacune des résistances Rp1 à Rp6 entre la borne 11 et une borne 13 d'application d'un potentiel de référence (par exemple, la masse à laquelle est connectée la résistance Rf). Cette connexion revient préférentiellement à transformer l'association en série des résistances Rp1 à Rp6 en une association parallèle de ces résistances entre les bornes 11 et 13. Pour sélectionner celles des résistances programmables auxquelles on applique la tension de programmation pour diminuer leurs valeurs respectives, on prévoit six commutateurs (un nombre égal au nombre de résistances) . Par exemple, trois transistors MOS à canal P MP2, MP4 et MP6 relient la borne 11 aux points milieux respectifs 14, 15 et 16 (ce dernier correspondant à la borne 12) entre les résistances Rp2 et Rp3, Rp4 et Rp5, Rp6 et Rf. Trois transistors MOS à canal N MN1, MN2 et MN3 relient respectivement les points milieux 17, 18 et 19 entre les résistances Rp1 et Rp2, Rp3 et Rp4, Rp5 et Rp6 à la masse 13.

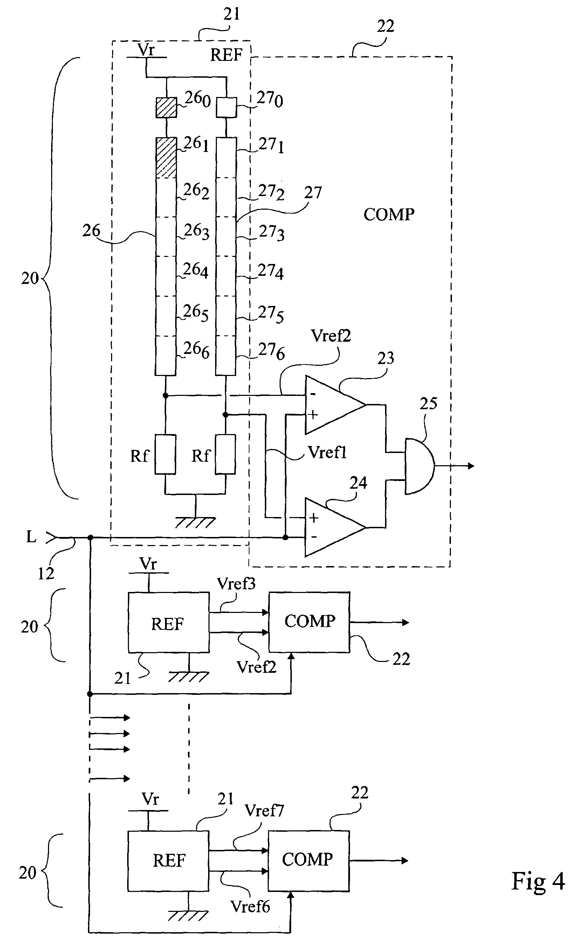

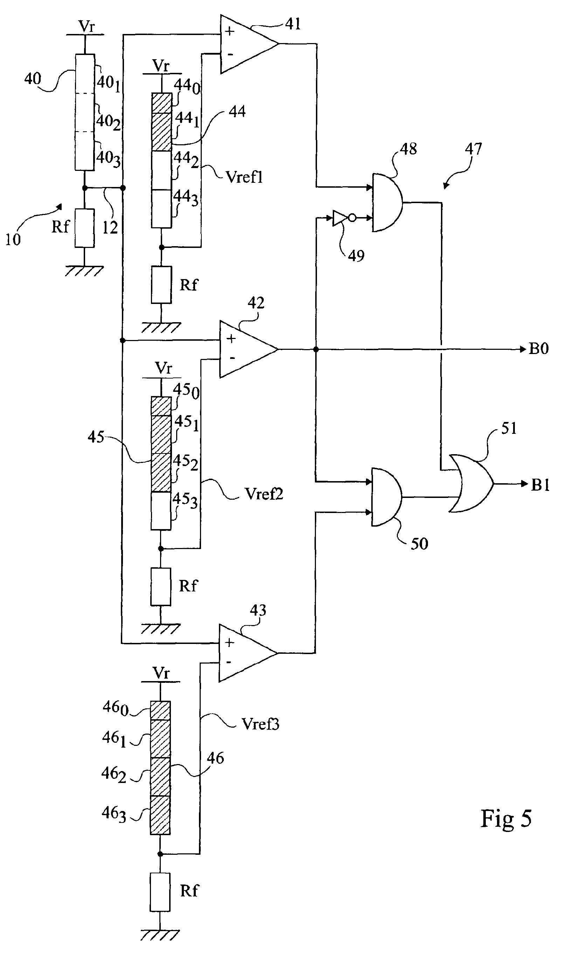

Les résistances Rp1 à Rp6 sont préférentiellement de valeurs identiques ou à tout le moins de même valeur que des résistances de référence de lecture qui seront décrites par la suite en relation avec les figures 4 et 5.

Pour programmer l'élément résistif de la cellule 10 de la figure 3 à un des niveaux possibles par diminution irréversible de la valeur d'une ou plusieurs des résistances Rp1 à Rp6, on peut soit effectuer cette programmation successivement et individuellement pour chacune des résistances concernées, soit effectuer cette diminution de façon collective selon un mode de réalisation préféré de l'invention. Par exemple, pour appliquer la tension de programmation Vp aux résistances Rp1, Rp2 et Rp3 simultanément, on provoque la fermeture des transistors MN1, MP2 et MN2. Il en résulte que les points 18 et 17 sont à la masse 13 alors que les points 11 et 14 sont à la tension Vp. Comme les transistors MP4 et MP6 sont bloqués (de même que optionnellement le transistor MN3), la tension Vp n'est pas appliquée sur les autres résistances Rp4 à Rp6. La génération de signaux S1 à S6 de commande respective des transistors MN1 à MP6 s'effectue par un circuit (non représenté) dont la constitution est à la portée de l'homme du métier à partir des indications données ci-dessus.

La figure 4 représente un premier mode de réalisation d'un circuit de lecture d'une cellule mémoire 10 telle que représentée en figure 3. Pour simplifier, on décrira le circuit de lecture et son fonctionnement en supposant qu'il est destiné à ne lire qu'une seule cellule 10 de la figure 3. On notera toutefois qu'un tel circuit peut être partagé par plusieurs cellules 10 agencées en réseau matriciel et sélectionnées par des circuits appropriés de décodage de colonnes et de rangées. En figure 4, la cellule 10 n'a pas été représentée, seule sa borne 12 de sortie destinée au circuit de lecture a été représentée.

Un circuit de lecture selon ce mode de réalisation comporte, de préférence, un étage 20 de plus que la cellule 10 à lire comporte de résistances programmables individuellement, ou plus précisément autant d'étages que de niveaux à détecter. Chaque étage est constitué d'un circuit 21 (REF) de génération de tensions de référence Vref1 et Vref2, Vref2 et Vref3, ..., Verf6 et Vref7, différentes l'une de l'autre, et d'un circuit 22 de comparaison (COMP) de ces valeurs de référence par rapport au niveau L lu sur la cellule 10. Chaque circuit de comparaison comporte deux comparateurs 23, 24 dont des entrées de type opposé (par exemple, respectivement non inverseuse et inverseuse) sont reliées à la borne 12 et dont les autres entrées respectives reçoivent les deux tensions de référence de l'étage. En figure 4, un seul étage 20 a été détaillé. Arbitrairement, on a choisi le premier étage.

Les tensions de référence sont destinées, pour chaque étage, à détecter combien de résistances parmi les Rp1 à Rp6 de la cellule 10 ont été ou non programmées par diminution irréversible de leur valeur. Selon un premier mode de réalisation, la tension de référence supérieure de chaque étage peut correspondre à la tension de référence inférieure de l'étage suivant. Dans ce cas, les tensions de référence sont générées de telle sorte que le niveau L lu soit compris entre les deux valeurs de référence par rapport auquel il est comparé si l'étage concerné est l'étage conditionnant le niveau final.

Les sorties respectives des comparateurs 23 et 24 de chaque circuit 22 sont combinées par une porte logique de type ET 25 dont la sortie fournit un état binaire indicateur d'un des niveaux stockables dans la cellule 10.

Dans l'exemple de la figure 4, la génération des tensions de référence fait appel à un mode de réalisation utilisant une structure identique à celle des cellules mémoire 10, à savoir, un même nombre de résistances programmables en série avec une résistance fixe Rf de même valeur que celle de la cellule 10. Pour simplifier la description, les deux résistances programmables 26 et 27 illustrées en figure 4 ont été symbolisées par une seule résistance de six tronçons $26_1$ à $26_6$ et $27_1$ à $27_6$ correspondant aux résistances programmables Rp1 et Rp6 de la figure 3. Les transistors de commutation des résistances n'ont pas été illustrés en figure 4. De préférence, les éléments résistifs 26 et 27 ont la même structure que ceux représentés en figure 3. En particulier, si les résistances Rp1 à Rp6 ne sont pas toutes de valeurs identiques, les résistances de même rang (1 à 6) des cellules 10 devant être lues ont les mêmes valeurs que celles des éléments résistifs 26 et 27 de référence. Ainsi, en préprogrammant les éléments résistifs 26 et 27 des différents circuits 21, on fixe des valeurs de référence correspondant respectivement aux différents niveaux possibles pour la cellule 10. En figure 4, on a symbolisé le fait que la valeur de la résistance $26_1$ ait été diminuée en hachurant le tronçon correspondant $26_1$ de l'élément résistif 26. L'élément résistif 27 est quant à lui à sa valeur d'origine pour garantir que le seuil Vref1 soit au moins égal à la valeur programmée.

De préférence et comme l'illustre la figure 4, les résistances $26_i$ et $27_i$ (i compris ici entre 1 et 6) ont toutes les mêmes valeurs dont la valeur programmée correspond, par exemple, à la moitié de la valeur non programmée. De plus, des tronçons résistifs supplémentaires $26_0$ et $27_0$ sont ajoutés en série avec les résistances 26 et 27, respectivement. Les valeurs de ces tronçons correspondent, dans un état non programmé, à la valeur programmée des autre tronçons et, dans un état programmé, par exemple à la moitié de la valeur programmée des autres tronçons, soit ici au quart de la valeur des autres tronçons non programmés. Un tel mode de réalisation permet de réutiliser le seuil supérieur d'un étage 20 comme seuil inférieur de l'étage suivant. La résistance $26_0$ (seuil Vref2) du premier étage est programmée alors que sa résistance $27_0$ (seuil Vref1) ne l'est pas. Par la suite, les résistances $26_0$ et $27_0$ de chaque étage correspondent à des valeurs programmées, ce qui permet de réutiliser les seuils supérieurs, sans modification, comme seuil inférieur de l'étage suivant.

Si seule la résistance Rp1 d'une cellule mémoire 10 lue a été programmée par diminution irréversible de sa valeur, la tension de la borne 12 sera supérieure à la tension de référence Vref1 mais inférieure à la tension de référence Vref2. Les sorties respectives des comparateurs 23 et 24 seront toutes deux à l'état haut et la porte 25 fournira un état haut. Tous les autres étages 20 du circuit de lecture fourniront des états bas dans la mesure où les seuils sont croissants et que le seuil Vref2 n'est pas atteint. Si aucune des résistances programmables de la cellule 10 n'a été programmée par diminution irréversible de sa valeur, tous les étages fournissent des états bas. Si par contre toutes les résistances ont été programmées par diminution irréversible de leur valeur respective, tous les étages fournissent un état haut. On voit donc que les états binaires fournis par les différents comparateurs 22 du circuit de lecture donnent une indication sur la programmation individuelle des résistances Rp1 à Rp6 de la cellule 10 lue, donc sur le niveau stocké dans cette cellule.

En prenant pour exemple, une valeur relative 1 pour une résistance $26_i$, on obtient les valeurs successives de seuil 5,75, 5,25, 4,75, 4,25, etc. Cela permet bien de détecter les états pris par la valeur L lue, à savoir 6, 5,5, 5, 4,5, etc.

La figure 5 représente un deuxième mode de réalisation d'un circuit de lecture d'une cellule mémoire ou d'une pluralité de cellules mémoire multi-niveaux selon la présente invention. En figure 5, la cellule 10 a été schématisée par un élément résistif 40 à trois tronçons $40_1$, $40_2$ et $40_3$ en série avec une résistance fixe Rf. Il s'agit toutefois de la même structure que celle illustrée par la figure 3, mais ne contenant ici que trois résistances programmables.

La borne 12 de lecture de la cellule est connectée aux entrées non inverseuses respectives de trois comparateurs 41, 42 et 43 dont les entrées inverseuses respectives reçoivent des tensions de référence Vref1, Vref2 et Vref3 correspondant aux programmations de la cellule 10 sur sa première résistance $40_1$, ses deux résistances $40_1$ et $40_2$ ou ses trois résistances $40_1$, $40_2$ et $40_3$, respectivement.

Selon un mode de réalisation préféré, les tensions de référence sont générées, comme pour le circuit de lecture précédent, au moyen de structures résistives identiques à celles des mémoires devant être lues, auxquelles sont ajoutés des tronçons correspondant à la moitié de la valeur prise par un tronçon programmé de l'élément 40. Ainsi, la tension Vref1 est générée par un élément résistif 44 dont seule la première résistance programmable $44_1$ a été préalablement programmée par diminution irréversible de sa valeur avec un tronçon $44_0$ également programmé, mais de valeur moitié. L'élément résistif 44 est en série avec une résistance Rf dont le point milieu est connecté à l'entrée inverseuse dans l'amplificateur 41. La tension Vref2 est obtenue par un élément résistif 45 dont les résistances $45_1$ et $45_2$ et un demi-tronçon $45_0$ ont été programmées et qui est connecté en série avec une résistance Rf, le point milieu de cette association en série étant relié à l'entrée inverseuse de l'amplificateur 42. De façon similaire, la tension Vref3 est obtenue par une cellule à élément résistif 46 dont les trois premiers éléments $46_1$, $46_2$ et $46_3$ et un demi-tronçon $46_0$ ont été programmés.

Le comparateur 41 fournit un état de sortie haut si la tension lue sur la cellule mémoire est supérieure au seuil Vref1. Respectivement, les amplificateurs 42 et 43 fournissent des états de sortie hauts si la tension lue sur la cellule mémoire 10 est supérieure aux seuils Vref2 et Vref3.

Les sorties des comparateurs 41, 42 et 43 sont exploités par un circuit logique 47 dont le rôle est de fournir une lecture de 4 niveaux sur deux bits B0 et B1 respectivement de poids fort et faible. La sortie du comparateur 42 fournit directement le premier bit B0 de poids fort. La sortie de la porte 41 est combinée par une porte 48 de type ET avec l'inverse (inverseur 49) de la sortie de la porte 42. La sortie du comparateur 42 est par ailleurs combinée par une porte de type ET 50 avec la sortie du comparateur 43. Les sorties respectives de portes 48 et 50 sont combinées par une porte 51 de type OU fournissant le bit de poids faible B1 du mot représentant le niveau stocké dans la cellule 10.

On notera que l'invention peut prendre pour base une cellule mémoire de capacité (en nombre de niveaux, donc de tronçons) plus importante que le nombre de niveaux exploités, ce dernier étant fixé par le circuit de lecture.

Le nombre de résistances programmables par diminution de leur valeur associées en série pour constituer une cellule mémoire selon l'invention peut être quelconque. Plus ce nombre est élevé, plus le nombre de niveaux détectables est élevé. Le nombre de programmations possibles d'une cellule selon l'invention dépend, si une seule tension de programmation est utilisée, du nombre de niveaux possibles de la cellule. En effet, comme la diminution de valeur est irréversible, la programmation d'une cellule ne peut s'effectuer que vers une diminution globale de la valeur de son élément résistif de mémorisation.

Un avantage de l'invention est que la programmation d'une cellule ne requiert pas de sélectionner des potentiels de programmation différents. L'invention est par conséquent compatible avec une consigne de programmation provenant d'un mot binaire commandant les différents transistors MP1 à MP6 (figure 3) de programmation.

Un autre avantage de l'invention est que la cellule mémoire multi-niveaux ainsi constituée est à programmation invisible, en ce sens que l'état programmé ou non programmé des différentes résistances ne peut pas être détecté optiquement à la différence de résistances fusibles.

On notera que le fait que la lecture de la cellule mémoire s'effectue alors que les résistances sont en série peut, dans certains cas, autoriser l'utilisation d'un seul et même potentiel Vp pour effectuer à la fois la lecture et la programmation. Il suffit que la valeur de la résistance Rf garantisse une absence de programmation des éléments Rp1 à Rp6 (c'est-à-dire, absorbe suffisamment de courant). Dans un tel cas, on inversera préférentiellement les connexions de la cellule 10 pour que la résistance Rf soit connectée au potentiel Vp et que l'élément résistif de la cellule soit connectée entre cette résistance et la masse. Cela permet de préserver, en aval, des amplificateurs de lecture qui fonctionnent sous une tension relativement basse.

Bien entendu, la présente invention est susceptible de diverses variantes et modifications qui apparaîtront à l'homme de l'art. En particulier, les dimensions des résistances en silicium polycristallin en vue d'obtenir une certaine valeur nominale dépendent de l'application et sont à la portée de l'homme du métier à partir des indications fonctionnelles données ci-dessus.

De plus, d'autres applications et circuits de commande et de lecture que ceux exposés ci-dessus à titre d'exemple pourraient être envisagées.

En outre, le nombre de résistances commandables Rp utilisables dans une cellule mémoire n'est pas limité. Elles peuvent même le cas échéant partager un même circuit de commande (transistors MN1 à MP6) si les circuits de sélection de cellules permettent d'isoler individuellement chacune des cellules mémoire.

Enfin, bien que le circuit de commande soit préférentiellement intégré avec la cellule mémoire, ce qui facilite la mise en oeuvre du procédé dans la vie de la mémoire, il n'est pas exclu d'utiliser un circuit séparé pour forcer le courant de contrainte dans les diverses résistances. A cet égard, les valeurs des contraintes en tension ou en courant pour la mise en oeuvre de l'invention sont à la portée de l'homme du métier à partir des indications fonctionnelles données ci-dessus.

**Revendications**

1. Cellule mémoire multi-niveaux, **caractérisée en ce qu'**elle comporte :

    un élément de mémorisation constitué de plusieurs résistances (Rp1, Rp2, Rp3, Rp4, Rp5, Rp6) en silicium polycristallin associées en série entre deux bornes (11, 12) d'entrée-sortie ; et
    une charge (Rf) en série avec ledit élément résistif, le point milieu (12) de cette association en série constituant une borne de lecture de la cellule mémoire, et les points milieux (14, 15, 17, 18, 19) respectifs entre lesdites résistances de l'élément de mémorisation étant accessibles.

2. Cellule selon la revendication 1, **caractérisée en ce qu'**au moins certains points parmi lesdits points milieux (14, 15, 17, 18, 19) de l'élément de mémorisation et le point milieu (16) entre cet l'élément et la charge, sont connectables, individuellement par un commutateur (MN1, MP2, MN3, MP4, MN5, MP6), soit à une desdites bornes (11, 12) d'entrée-sortie de l'élément de mémorisation, soit à une borne (13) d'application d'un potentiel prédéterminé.

3. cellule selon la revendication 2, **caractérisée en ce que** les extrémités d'une même résistance (Rp1, Rp2, Rp3, Rp4, Rp5, Rp6) ne sont pas connectables à la même borne.

4. Cellule selon la revendication 2 ou 3, **caractérisée en ce que** lesdits commutateurs sont constitués de transistors MOS répartis pour moitié en transistors à canal P (MP2, MP4, MP6) et en transistors à canal N (MN1, MN3, MN5).

5. Cellule selon l'une quelconque des revendications 1 à 4, **caractérisée en ce que** toutes les résistances en silicium polycristallin (Rp1, Rp2, Rp3, Rp4, Rp5, Rp6) ont des valeurs nominales identiques.

6. Cellule selon l'une quelconque des revendications 1 à 5, **caractérisée en ce que** le nombre de niveaux programmables possibles correspond, au maximum, au nombre de résistances en silicium polycristallin (Rp1, Rp2, Rp3, Rp4, Rp5, Rp6) de l'élément de mémorisation, plus un.

7. Cellule mémoire selon l'une quelconque des revendications 1 à 6, **caractérisée en ce que** la programmation s'effectue en imposant, dans une ou plusieurs desdites résistances en silicium polycristallin de l'élément de mémorisation, un courant de contrainte supérieur à un courant pour lequel la valeur de cette résistance présente un maximum.

8. Cellule selon la revendication 7, **caractérisé en ce que** ledit courant de contrainte est situé au-delà d'une plage de courant de fonctionnement en lecture de l'élément de mémorisation.

9. Circuit de lecture d'au moins une cellule mémoire conforme à l'une quelconque des revendications 1 à 8, **caractérisé en ce qu'**il comporte un ensemble de comparateurs (23, 24 ; 41, 42, 43) recevant respectivement, sur une première entrée, la tension aux bornes d'entrée-sortie (11, 12) de l'élément de mémorisation et, sur une deuxième entrée, une tension de référence (Vref) choisie en fonction d'un niveau à détecter par le comparateur parmi les niveaux possibles souhaités.

10. Circuit selon la revendication 9, **caractérisé en ce qu'**il comporte un comparateur de moins qu'il existe de niveaux que l'on souhaite distinguer dans la cellule mémoire, et un ensemble de portes logiques générant autant d'états qu'il y a de comparateurs, le mot binaire fourni par ledit ensemble représentant l'état de la cellule mémoire.

11. Circuit selon la revendication 9, **caractérisé en ce qu'**il comporte un nombre de comparateurs égal au double du nombre de niveaux que l'on souhaite distinguer dans la cellule, les sorties des comparateurs étant combinées deux à deux dans l'ordre croissant des tensions de référence qu'il reçoivent, pour détecter un niveau par paire de comparateurs.

Fig 1

Fig 2

Fig 3

Fig 4

Fig 5